# EUROPÄISCHE PATENTSCHRIFT

(11) **EP 0 417 643 B1**
(45) Veröffentlichungstag und Bekanntmachung des Hinweises auf die Patenterteilung: **07.06.1995**
(21) Anmeldenummer: 90117161.1
(22) Anmeldetag: 06.09.1990
(51) Int. Cl.: H01J 37/07

(54) **Elektronenstrahlerzeuger, insbesondere für eine Elektronenstrahlkanone**
Electron beam producing device, particularly for an electron gun
Dispositif de production de faisceaux d'électrons, en particulier pour canon à électrons

(30) Priorität: 12.09.1989 DE 3930399
(43) Veröffentlichungstag der Anmeldung: 20.03.1991
(73) Patentinhaber: PTR PRÄZISIONSTECHNIK GMBH, 63461 Maintal (DE)
(72) Erfinder: Fritz, Dieter, D-6460 Gelnhausen (DE); Schwarz, Wolfgang, Dr., D-6464 Linsengericht (DE); Spruck, Helmut, D-8031 Gilching (DE)
(74) Vertreter: Sartorius, Peter, Dipl.-Ing.

(56) Entgegenhaltungen:
- DE-A- 1 564 310
- DE-A- 1 789 178
- DE-B- 1 589 974
- US-A- 4 574 178

## Beschreibung

Die Erfindung betrifft einen Elektronenstrahlerzeuger, insbesondere für eine Elektronenstahlkanone, mit einem in einem Gehäuse angeordneten Hochspannungsisolator, der eine Glühkathode und eine Steuerelektrode trägt, die mit einem Hochspannungsanschluß verbindbar sind.

Ein Elektronenstrahlerzeuger der angegebenen Art ist aus der DE-OS 33 33 686 bekannt. Bei derartigen Elektronenstrahlerzeugern kommt es durch die hohe Temperatur der Glühkathode zu einer starken Erwärmung der dieser benachbarten Bauteile. Bei dem bekannten Elektronenstrahlerzeuger sind zur Vermeidung einer unzulässigen Erwärmung in dem Hochspannungsisolator Kühlmittelkanäle angeordnet, die aus Kunststoff bestehen und in die Gießharzmasse des Hochspannungsisolators eingegossen sind. Als Kühlmittel wird zur Vermeidung zu großer Potentialsprünge Transformatorenöl durch die Kühlmittelkanäle geleitet.

In einer oberhalb der Kühlmittelkanäle liegenden, zentralen Ausdehnung des Hochspannungsisolators befindet sich eine Kapsel aus ferromagnetischem Werkstoff, in der Schaltelemente für die Gleichrichtung und Siebung der Wehnelt-Spannung und des Kathodenheizstroms untergebracht sind. Von der Kapsel führen Anschlußleitungen zu der unterhalb der Kühlmittelkanäle angeordneten Kathode und Steuerelektrode. Im Innern des Hochspannungsisolators vorhandene Freiräume sind ebenfalls mit Öl gefüllt, um starke Potentialsprünge auszuschließen und den Wärmetransport zu erleichtern. Diese bekannten Maßnahmen zur Kühlung des Elektronenstrahlerzeugers haben sich nicht als ausreichend effektiv erwiesen. Die Wärme gelangt von der Kathode und der Steuerelektrode nur über verhältnismäßig große Wege im Hochspannungsisolator in den Bereich des Kühlmittelkanäle und der Wärmeübergang von Hochspannungsisolator zum Kühlöl in den Kühlmittelkanälen ist ungünstig. Hierdurch ergibt sich ein erhebliches Temperaturgefälle, so daß die Temperatur an der Kathodenhalterung und der Steuerelektrode die zulässige Höhe überschreiten kann. Auch der Wärmetransport durch das Isolieröl im Innern des Strahlerzeugers wird erst bei höheren Temperaturen wirksam, da die natürliche Konvektion erst ab circa 130 °C in der Lage ist, nennenswerte Wärmemengen zu transportieren. Schließlich erweist sich bei dem bekannten Elektronenstrahlerzeuger die Anordnung der Kühlkanäle in baulicher Hinsicht als nachteilig, da hierdurch die Bauhöhe des Strahlkopfs größer und die Anschlüsse für die Kathode und die Steuerelektrode länger werden.

Der Erfindung liegt die Aufgabe zugrunde, einen Elektronenstrahlerzeuger der eingangs genannten Art zu schaffen, der sich durch eine bereits bei einem niedrigen Temperaturniveau wirksame Kühlung auszeichnet.

Ein Elektronenstrahlerzeuger der angegebenen Art ist aus der DE AS 17 89 178 (Spruck, Steigerwald) bekannt. Diese Druckschrift zeigt einen Elektronenstrahlerzeuger, insbesondere für eine Elektronenstrahlkanone, mit einem in einem Gehäuse angeordneten Hochspannungsisolator, der eine Glühkathode und eine Steuerungselektrode trägt, die mit einem Hochspannungsanschluß verbindbar sind, wobei die Anschlußklemmen des Kathodenträgers oder zusätzlich auch die Steuerelektrode über als Wärmeleitbrücken ausgebildete Anschlußleitungen mit Kühlplatten im Innern des Hochspannungsisolators verbunden sind. Dieser steht wiederum mit einem Kühlkreislauf in Wirkverbindung.

Erfindungsgemäß ist zusätzlich ein Kühlkörper vorgesehen, der aus einem Topf besteht und dessen ebener Boden auf einer Isolatorscheibe aufliegt, und wobei die Kühlplatten über die Isolatorscheibe wärmeleitend mit dem Kühlkörper in Verbindung stehen, der von einem Kühlkreislauf gekühlt wird, wobei die aufgenommene Wärme über die Seitenwand des Kühlkörpers an einen ringförmigen Wärmetauscher des Kühlkreislaufs abgegeben wird.

Bei der Erfindung wird die Wärme von der Kathode bzw. der Steuerelektrode durch Bauelemente abgeführt, die aufgrund ihres Materials oder ihrer geometrischen Form eine hohe Wärmeleitfähigkeit haben und bereits bei einem niedrigen Temperaturgefälle wirksam sind. Auf diese Weise wird es möglich, die Temperatur des Kathodenhalters und der Steuerelektrode auf einem verhältnismäßig niedrigen Niveau zu halten, was für das thermische Verhalten des Elektronenstrahlerzeugers und für seine Betriebssicherheit sehr vorteilhaft ist. Für den Wärmetransport werden dabei in vorteilhafter Weise vorhandene Bauteile, wie die Anschlußleitungen genutzt, wodurch der Bauaufwand niedrig und die äußeren Abmessungen des Strahlerzeugers klein gehalten werden können. Während bei den Anschlußleitungen durch die Wahl des Werkstoffs, z.B. Kupfer oder eine Kupferlegierung und die Dimensionierung eines Querschnitts eine günstige Wärmeleitfähigkeit erreicht werden kann, ermöglichen die mit den Anschlußleitungen verbundenen Kühlplatten durch ihre verhältnismäßig große Oberfläche, mit der sie an der Isolatorscheibe anliegen, einen effektiven Wärmetransport zu dem auf der anderen Seite der Isolatorscheibe aufliegenden Kühlkörper.

Um eine einfache bauliche Ausgestaltung zu erzielen, ist erfindungsgemäß weiterhin vorgesehn, daß die Kühlplatten in einer gemeinsamen Ebene liegen und durch Stege des Hochspannungsisolators voneinander getrennt sind. Die beiden Kühlplatten der Kathodenanschlüsse und die Kühlplatte des Anodenanschlusses bilden somit eine einheitliche, ebene Auflagefläche für die Isolatorscheibe und den darüberliegenden Kühlkörper. Erfindungsgemäß kann weiterhin vorgesehen sein, daß die Kühlplatten an Kontakte anschließbar sind, die durch Öffnungen in der Isolatorscheibe und im Kühlkörper hindurchgreifen und die Glühkathode bzw. die Steuerelektrode mit der Hochspannungsversorgung verbinden. Die Kühlplatten bilden somit gleichzeitig einen Abschnitt des elektrischen Anschlusses wobei sie aufgrund ihrer räumlichen Ausdehnung dem Konstrukteur einen Freiraum für die Positionierung der zur Hochspannungsversorgung führenden Kontakte ermöglichen.

Die Isolatorscheibe kann erfindungsgemäß aus einem Kunststoff oder aus einem keramischen Wirkstoff bestehen. Als besonders vorteilhaft hat sich die Herstellung der Isolatorscheibe aus dem unter dem Handelsnamen "Kaptan" bekannten Werstoff erwiesen.

Der Kühlkörper kann nach einem weiteren Vorschlag der Erfindung vorteilhaft aus einem Topf bestehen, dessen ebener Boden auf der Isolatorscheibe aufliegt und über dessen Seitenwand die aufgenommene Wärme an einen Wärmetauscher des Kühlkreislaufs abgegeben wird. Der Kühlkörper selbst zeichnet sich ebenfalls durch eine hohe Wärmeleitfähigkeit aus und ist vorzugsweise aus Kupfer oder einer Kupferlegierung hergestellt. Eine bauliche Vereinfachung des Elektronenstrahlerzeugers läßt sich erfindungsgemäß auch dadurch erreichen, daß der Topf des Kühlkörpers Teil einer als Faraday'scher Käfig ausgebildeten Kapsel ist, in der Schaltungselemente zur Steuerung des Elektonenstrahlerzeugers angeordnet ist.

Erfindungsgemäß kann weiterhin vorgesehen sein, daß der die Seitenwand des Kühlkörpers innerhalb des Gehäuses ringförmig umgreifende Wärmetauscher auf Erdpotential liegt und durch eine Wand des Hochspannungsisolators von der Wand des Kühlkörpers getrennt ist. Diese Ausgestalltung hat den Vorteil, daß im Kühlkreislauf Wasser verwendet werden kann. Die schlechte Wärmeleitung der Wand des Hochspannungsisolators zwischen Kühlkörper und Wärmetauscher ist dabei ohne Nachteil, da aufgrund des großen Durchmessers zwischen der Seitenwand des Kühlkörpers und dem Wärmetauscher eine große Fläche für den Wärmeübergang vorhanden ist.

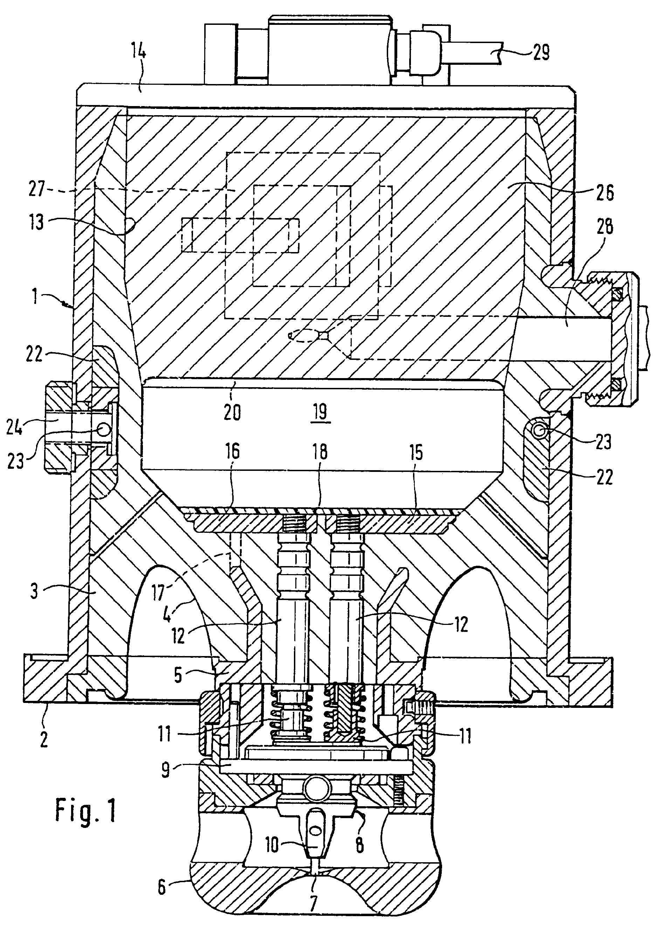

Die Erfindung wird nachfolgend anhand eines Ausführungsbeispiels näher erläutert, das in der Zeichnung dargestellt ist. Es zeigen
- Figur 1: einen Längsschnitt durch einen erfindungsgemäßen Elektronenstrahlerzeuger für den Einbau in eine Elektronenstrahlkanone und
- Figur 2: eine Draufsicht auf den Elektronenstrahlerzeuger gemäß Figur 1 nach Entfernen des Gehäusedeckels und Herausnahme der über den Kühlplatten angeordneten Einbauteile.

Der dargestellte Elektronenstrahlerzeuger besteht aus einem zylindrischen Gehäuse 1, das mit einem Befestigungsflansch 2 vakuumdicht auf einer nicht dargestellten Beschleunigungskammer befestigbar ist, in der sich eine Beschleunigungsanode befindet. Das Gehäuse 1 enthält einen Hochspannungsisolator 3, der an seiner Unterseite im Zentrum einer ringförmigen Ausdehnung 4 an einem Befestigungsflansch 5 eine Steuerelektrode 6 und eine Glühkathode 7 trägt. Die Glühkathode 7 ist an einem Kathodenträger 8 angeordnet, der mit einem Isolierlager 9 in der Steuerelektrode 6 gelagert ist. Die Glühkathode 7 ist an zwei Anschlußklemmen 10 des Kathodenträgers befestigt, die jeweils über einen federnden Kontakt 11 mit einer durch einen Stift oder Zapfen gebildeten Anschlußleitung 12 im Hochspannungsisolator 3 thermisch und elektrisch leitend verbunden sind.

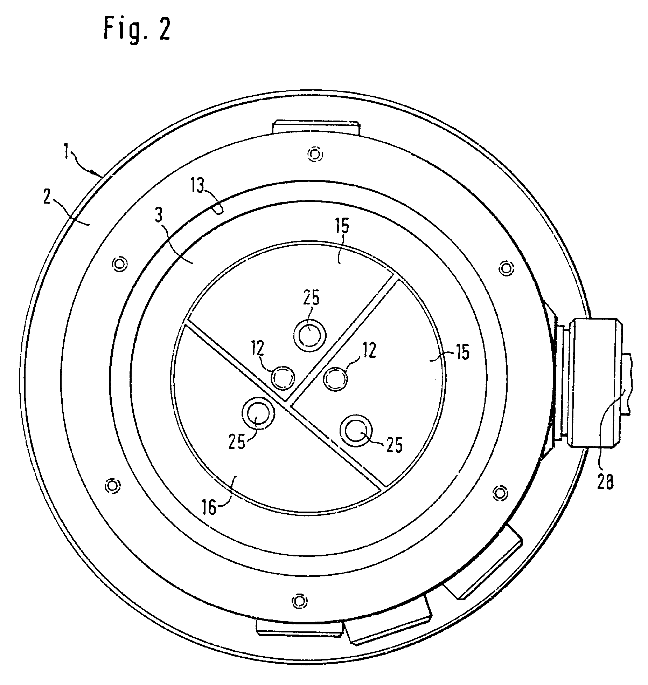

Auf seiner Oberseite weist der Hochspannungsisolator 3 eine mittige Ausnehmung 13 auf, die durch eine mit einem Deckel 14 verschließbare Öffnung im Gehäuse 1 für den Einbau verschiedener Aggregate zugänglich ist. Am Boden der Ausnehmung 13 befinden sich zwei Kühlplatten 15, die durch einen Steg des Hochspannungsisolators 3 voneinander getrennt und jeweils mit einer Anschlußleitung 12 durch Verschraubung fest verbunden sind. In einer Ebene mit den Kühlplatten 15 ist eine lediglich in Figur 2 sichtbare Kühlplatte 16 vorgesehen, die über eine durch einen Steg gebildete Anschlußleitung 17 mit dem Befestigungsflansch 5 verbunden ist. Die Kontakte 11, die Anschlußleitungen 12 und die Anschlußleitung 17 bestehen aus einem metallischen Werkstoff hoher Wärmeleitfähigkeit und bilden dadurch Wärmeleitbrücken, die die von der Glühkathode an die Anschlußklemmen 10 und die Steuerelektrode 6 abgegebene Wärme zu den Kühlplatten 15, 16 weiterleiten.

Wie aus Figur 2 ersichtlich, füllen die Kühlplatten 15, 16 die kreisförmige Bodenfläche der Ausnehmung 13 im wesentlichen aus. Sie sind nach oben durch eine kreisrunde Isolatorscheibe 18 abgedeckt, auf der der Boden eines topfförmigen Kühlkörpers 20 aufliegt, der den unteren Bereich der Ausnehmung 13 vollständig ausfüllt. Der Kühlkörper 19 besteht ebenfalls aus einem Material guter elektrischer und thermischer Leitfähigkeit und bildet eine durch einen Deckel 20 verschlossene Kapsel, die die Wirkung eines Faraday'schen Käfigs hat und eine elektrische Schaltungsanordnung zur Steuerung des Elektonenstrahlerzeugers enthält. Die Kühlplatten 15, 16 sind über Steckkontakte 25, die sich durch Öffnungen in der Isolatorscheibe 18 und im Boden des Kühlkörpers 19 erstrecken, an die Schaltungsanordnung in der durch den Kühlkörper 19 gebildeten Kapsel angeschlossen.

Im Bereich der Seitenwand des Kühlkörpers 19 weist der Hochspannungsisolator 3 in seiner dem Gehäuse 1 zugekehrten Außenfläche eine ringförmige Ausnehmung 21 auf, in der sich ein Wärmetauscher 22 mit einem von einer Kühlflüssigkeit, beispielsweise Wasser, durchströmten Kühlkanal 23 befindet. Über eine Öffnung 24 im Gehäuse 1 ist der Kühlkanal 23 an einen Kühlkreislauf anschließbar.

Im oberen Teil der Ausnehmung 13 befindet sich ein Isolierkörper 26, der einen Isoliertransformator 27 enthält, der als Stromwandler für den Kathodenheizstrom dient. Über einen Hochspannungsanschluß 28 ist der Elektronenstrahlerzeuger an eine Hochspannungsversorgung anschließbar. Ein Weiterer, auf dem Deckel 14 angeordneter Spannungsanschluß 29 auf Erdpotential dient zur Speisung der Primärwicklung des Isoliertransformators 27.

Der beschriebene Elektronenstrahlerzeuger ermöglicht bei einem einfachen und kompakten Aufbau eine gute Kühlung des Kathodenträgers 8 und der Steuerelektrode 6 durch eine wirksame Wärmeableitung über die Stromdurchführungen im Hochspannungsisolator 3 und den die elektrische Schaltungsanordnung aufnehmenden Kühlkörper 19 Um auch im Bereich der Isolatoren zwischen den Wärmeleitbrücken und dem Kühlkörper, sowie zwischen dem Kühlkörper und dem Wärmetauscher einen genügend wirksamen Wärmetransport zu gewährleisten, sind diese Bereiche möglichst dünnwandig und großflächig ausgebildet. Der Wärmetauscher 22 befindet sich auf Erdpotential und stellt daher an den Kühlkreislauf keine besonderen Anforderungen. Da der Wärmetransport vom Strahlerzeuger zum Wärmetauscher ausschließlich durch Wärmeleitung in Festkörpern erzielt wird, ist er schon bei niedrigen Temperaturen wirksam, so daß auch die Temperatur des Strahlerzeugers vorteilhaft niedrig gehalten werden kann.

## Patentansprüche

1. Elektronenstrahlerzeuger, insbesondere für eine Elektronenstrahlkanone, mit einem in einem Gehäuse angeordneten Hochspannungsisolator, der eine Glühkathode und eine Steuerungselektrode trägt, die mit einem Hochspannungsanschluß verbindbar sind, wobei die Anschlußklemmen (10) des Kathodenträgers (8) oder zusätzlich auch die Steuerelektrode (6) über als Wärmeleitbrücken ausgebildete Anschlußleitungen (12, 17) mit Kühlplatten (15, 16) im Innern des Hochspannungsisolators (3) verbunden sind, dadurch gekennzeichnet, daß ein Kühlkörper (19) vorgesehen ist, der aus einem Topf besteht und dessen ebener Boden auf einer Isolatorscheibe (18) aufliegt, und wobei die Kühlplatten (15, 16) über die Isolatorscheibe (19) wärmeleitend mit dem Kühlkörper (19) in Verbindung stehen, der von einem Kühlkreislauf (23) gekühlt wird, wobei die aufgenommene Wärme über die Seitenwand des Kühlkörpers (19) an einen ringförmigen Wärmetauscher (22) des Kühlkreislaufs (23) abgegeben wird.

2. Elektronenstrahlerzeuger nach Anspruch 1, dadurch gekennzeichnet, daß die Kühlplatten (15, 16) in einer gemeinsamen Ebene liegen und durch Stege des Hochspannungsisolators (3) voneinander getrennt sind.

3. Elektronenstrahlerzeuger nach einem der Ansprüche 1 oder 2, dadurch gekennzeichnet, daß die Kühlplatten (15, 16) an Kontakte (25) anschließbar sind, die durch Öffnungen in der Isolatorscheibe (18) und im Kühlkörper (19) hindurchgreifen und die Glühkathode (7) bzw. die Steuerelektrode (6) mit der Hochspannungsversorgung verbinden.

4. Elektronenstrahlerzeuger nach einem der vorhergehenden Ansprüche, dadurch gekennzeichnet, daß die Isolatorscheibe (18) aus einem Kunststoff oder aus einem keramischen Werkstoff, vorzugsweise aus dem unter dem Handelsnamen "Kaptan" bekannten Werkstoff, besteht.

5. Elektronenstrahlerzeuger nach einem der vorhergehenden Ansprüche, dadurch gekennzeichnet,daß der Kühlkörper (19) aus einem Werkstoff hoher thermischer und elektrischer Leitfähigkeit, vorzugsweise aus Kupfer oder einer Kupferlegierung, besteht.

6. Elektronenstrahlerzeuger nach einem der vorhergehenden Ansprüche, dadurch gekennzeichnet, daß der Kopf des Kühlkörpers (19) Teil einer als Faradayscher Käfig ausgebildeten Kapsel ist, in der Schaltungselemente zur Steuerung des Elektronenstrahlerzeugers angeordnet sind.

7. Elektronenstrahlerzeuger nach einem der vorhergehenden Ansprüche, **dadurch gekennzeichnet, daß** der die Seitenwand des Kühlkörpers (19) innerhalb des Gehäuses (1) ringförmig umgreifende Wärmetauscher (22) auf Erdpotential liegt und durch eine Wand des Hochspannungsisolators (2) von der Wand des Kühlkörpers (19) getrennt ist.

## Claims

1. An electron beam generator, especially for an electron beam gun, having a high-voltage insulator disposed in a casing and bearing an incandescent cathode and a control electrode, both connectable to a high-voltage terminal, whereby the terminals (10) of the cathode holder (8) or additionally the control electrode (6) are attached by connecting wires (12, 17) configured as heat conducting bridges, with cooling plates (15, 16) inside of the high-voltage insulator (3), characterized in that there is a cooling body (19) which consists of a pot whose flat bottom lies on an insulator disk (18), and the cooling plates (15, 16) communicate in a thermally conductive manner through the insulator disk (18) with the cooling body (19), which is cooled by a cooling circuit (23) and through whose side wall the absorbed heat is yielded to an annular heat exchanger (22) in the cooling circuit (23).

2. Electron beam generator according to Claim 1, characterized in that the cooling plates (15, 16) lie in a common plane and are separated from one another by ridges on the high-voltage insulator (3).

3. Electron beam generator according to one of Claims 1 or 2, characterized in that the cooling plates (15, 16) can be joined to contacts (25) passing through openings in the insulating disk (18) and in the cooling body (19) and connecting the incandescent cathode (7) and the control electrode (6) to the high-voltage power supply.

4. Electron beam generator according to one of the preceding Claims, characterized in that the insulating disk (18) consists of a plastic or a ceramic material, preferably of the material known by the trade name, "Kaptan."

5. Electron beam generator according to one of the preceding Claims, characterized in that the cooling body (19) consists of a material of good electrical and thermal conductivity, and is preferably made of copper or a copper alloy.

6. Electron beam generator according to one of the preceding Claims, characterized in that the pot of the cooling body (19) is part of a capsule configured as a Faraday shield in which circuitry is arranged for the control of the electron beam generator.

7. Electron beam generator according to one of the preceding Claims, characterized in that the heat exchanger reaches annularly around the side wall of the cooling body (19) inside of the casing (1), with the heat exchanger (22) at ground potential and separated from the wall of the cooling body (19) by a wall of the high-voltage insulator (2).

## Revendications

1. Générateur de faisceaux électroniques destiné en particulier à un canon à électrons et comportant un isolateur haute tension disposé dans un boîtier et portant une cathode à incandescence et une électrode de commande pouvant être branchées à un raccord haute tension, les bornes de raccordement (10) du porte-cathode (8) ou encore l'électrode de commande (6) étant reliées à des plaques de refroidissement (15, 16) à l'intérieur de l'isolateur H.T. (3) par l'intermédiaire de conduites de raccordement (12, 17) formant des ponts conducteurs de la chaleur, caractérisé en ce qu'un refroidisseur (19) sous forme de pot est prévu dont le fond plat repose sur un disque d'isolateur (18), les plaques de refroidissement (15, 16) reliées de façon thermoconductrice au refroidisseur (19) par l'intermédiaire du disque d'isolateur (18), ledit refroidisseur étant refroidi par un circuit réfrigérant (23) et la chaleur absorbée étant transmise à un échangeur thermique annulaire (22) du circuit réfrigérant (23) en passant par la paroi latérale du refroidisseur (19).

2. Générateur de faisceaux électroniques suivant la revendication 1, caractérisé en ce que les plaques de refroidissement (15, 16) se trouvent dans un plan commun et sont séparées l'une de l'autre par des entretoises de l'isolateur H.T. (3).

3. Générateur de faisceaux électroniques suivant la revendication 1 ou 2, caractérisé en ce que les plaques de refroidissement (15, 16) peuvent être branchées à des contacts (25) qui passent à travers des ouvertures dans le disque d'isolateur (18) et dans le refroidisseur (19) pour raccorder la cathode à incandescence (7) et l'électrode de commande (6) à l'alimentation en haute tension.

4. Générateur de faisceaux électroniques suivant l'une quelconque des revendications 1 à 3, caractérisé en ce que le disque d'isolateur (18) est en matière plastique ou en céramique, de préférence en un matériau connu sous la marque "Kaptan".

5. Générateur de faisceaux électroniques suivant l'une quelconque des revendications 1 à 4, caractérisé en ce que le refroidisseur (19) consiste en un matériau à haute conductibilité thermique et électrique, de préférence en cuivre ou en alliage de cuivre.

6. Générateur de faisceaux électroniques suivant l'une quelconque des revendications 1 à 5, caractérisé en ce que la tête du refoidisseur (19) fait partie d'une capsule sous forme de cage de Faraday, dans laquelle sont disposés des éléments de circuit pour la commande du générateur de faisceaux électroniques.

7. Générateur de faisceaux électroniques suivant l'une quelconque des revendications 1 à 6, caractérisé en ce que l'échangeur thermique (22) qui entoure la paroi latérale du refroidisseur (19) à l'intérieur du boîtier (1) comme un anneau, est mis à la terre et qu'une paroi de l'isolateur H.T. (2) le sépare de la paroi du refroidisseur (19).
